# DEMANDE DE BREVET EUROPEEN

(11) **EP 1 292 178 A1**
(43) Date de publication de la demande: **12.03.2003**
(21) Numéro de dépôt: 02292198.5
(22) Date de dépôt: 06.09.2002
(51) Int. Cl.: H05K 7/14, F16F 15/08

(54) **Suspension pour module électronique devant fonctionner durant et aprés impacts sévères**

(30) Priorité: 07.09.2001 FR 0111617
(71) Demandeur: TDA ARMEMENTS S.A.S., 45240 La Ferté Saint-Aubin (FR)
(72) Inventeur: Gamby, Bruno, Thales Intellectual Property, 94117 Arcueil Cedex (FR); Ruelle, Didier, Thales Intellectual Property, 94117 Arcueil Cedex (FR)
(74) Mandataire: Lucas, Laurent Jacques

(57) **Abrégé**

La présente invention concerne une suspension pour module électronique. Cette suspension comprend au moins :
- une première structure rigide (2) ;
- une seconde structure rigide (3), destinée à être fixée à la première structure rigide, la première et la seconde structure formant une cavité (10) une fois fixées ensemble ;
- un ou plusieurs absorbeurs de chocs (5, 6, 7, 8), destinés à être en contact avec la surface de ladite cavité ;
- un enrobage rigide (4) du module électronique (1), destiné à être placé dans ladite cavité (10) en contact avec les absorbeurs de chocs (5, 6, 7, 8) et découplé mécaniquement de la cavité, les absorbeurs de chocs étant précontraints (F) lorsque la première et la seconde structure sont fixées ensemble, par la cavité d'une part et l'enrobage rigide d'autre part, chaque absorbeur de chocs adhérant à l'enrobage rigide ou à la cavité ou aux deux.

L'invention s'applique notamment aux modules électroniques des appareils de mesure et d'enregistrement (crash test, boîtes noires d'avion par exemple), aux modules électroniques des appareils destinés à être éjectés (micro satellites par exemple) et aux modules électroniques des munitions destinées à fonctionner après un impact (munitions de pénétration).

## Description

La présente invention concerne une suspension pour module électronique. Elle s'applique notamment aux modules électroniques des appareils de mesure et d'enregistrement (crash test, boîtes noires d'avion par exemple), aux modules électroniques des appareils destinés à être éjectés (micro satellites par exemple) et aux modules électroniques des munitions destinées à fonctionner après un impact (munitions de pénétration).

Les munitions de pénétration (missiles anti-infrastructure, bombes, pénétrateurs) comprennent généralement une électronique très simple. Cette électronique peut être un circuit RC assurant un retard de mise à feu. D'autres fonctions sont assurées, avant impact uniquement, de manière mécanique. On peut par exemple inhiber la chaîne pyrotechnique jusqu'au largage de la munition, en utilisant des volets obturateurs. Ces volets empêchent d'initier la chaîne pyrotechnique accidentellement. Cependant ces munitions sont relativement rudimentaires. Il est souhaitable pour les améliorer d'ajouter des fonctions électroniques nouvelles, ces fonctions devant fonctionner après impact. A cet effet, on peut remplacer par exemple les volets obturateurs par une commande électronique d'initiation à haute énergie. L'inhibition mécanique n'est plus nécessaire car seule une énergie importante peut initier la chaîne pyrotechnique. On peut alors ajouter des fonctions électroniques de gestion de la sécurité (tests du bon déroulement d'une séquence opérationnelle) permettant de contrôler, même après impact, la commande électronique d'initiation.

Cependant l'électronique à protéger présente alors un volume et un poids beaucoup plus important. De plus le nombre de composants électroniques, et donc de jonctions, à protéger est plus important. Enfin, les composants électroniques permettant de commander l'initiation doivent fonctionner à de hautes énergies. De tels composants sont volumineux et fragiles. Le problème se pose alors de protéger pendant et après un impact de plusieurs milliers de G, un module électronique comportant plus de fonctions, des composants électroniques fragiles, et constituant une électronique beaucoup plus volumineuse qu'un simple circuit RC.

Conformément à la présente invention, ce problème est résolu au moyen d'une suspension pour module électronique. Cette suspension comprend au moins :
- une première structure rigide ;
- une seconde structure rigide, destinée à être fixée à la première structure rigide, la première et la seconde structure formant une cavité une fois fixées ensemble ;
- un ou plusieurs absorbeurs de chocs, destinés à être en contact avec la surface de ladite cavité ;
- un enrobage rigide du module électronique, destiné à être placé dans ladite cavité en contact avec les absorbeurs de chocs et découplé mécaniquement de la cavité, les absorbeurs de chocs étant précontraints lorsque la première et la seconde structure sont fixées ensemble, par la cavité d'une part et l'enrobage rigide d'autre part, chaque absorbeur de chocs adhérant à l'enrobage rigide ou à la cavité ou aux deux.

Avantageusement, les absorbeurs de chocs sont constitués par des dépôts de matière élastique.

Avantageusement, l'enrobage est constitué par une résine rigide.

Avantageusement, la forme et la constitution des absorbeurs de chocs sont adaptées de manière à atténuer les accélérations transmises de la première et la seconde structure à l'enrobage rigide, et cette atténuation étant suffisante pour protéger le module électronique contre des accélérations à des fréquences supérieures à 1kHz.

L'invention concerne aussi un dispositif comprenant un premier module électronique et une suspension conformément à l'invention, pour ce premier module électronique. Ce dispositif comprend en outre un ou plusieurs seconds modules, ces seconds modules étant des modules électroniques ou des équipements, ces seconds modules étant découplés mécaniquement du premier module électronique, mais relié électriquement à ce premier module.

Avantageusement, l'un des seconds modules est fixé à la première ou la seconde structure rigide de la suspension.

Avantageusement, la liaison électrique entre le premier module et au moins l'un des seconds modules est une liaison électrique souple, cette liaison électrique pouvant être détruite lorsque la première et la seconde structures subissent des accélérations violentes, cette destruction ne perturbant pas le fonctionnement du premier module électronique.

Avantageusement, la liaison électrique souple est formée par un ou plusieurs fils ou une nappe de fils.

Avantageusement, la liaison électrique entre le premier module et l'un des seconds modules est une liaison électrique élastique, cette liaison élastique permettant d'accepter les mouvements relatifs entre le premier et le second module, même lorsque la première et la seconde structures subissent des accélérations violentes.

Avantageusement, la liaison électrique élastique comprend une ou plusieurs pinces élastiques conductrices.

L'invention présente de nombreux avantages. Elle est simple à mettre en oeuvre, elle permet un assemblage rapide et elle est économique.

La présente invention sera mieux comprise à la lecture de la description détaillée d'un mode réalisation, pris à titre d'exemple non limitatif et illustré par les dessins annexés, sur lesquels ;
- la figure 1, un schéma, représente un exemple de réalisation de l'invention ;
- la figure 2, une vue en coupe verticale, représente un exemple de réalisation conformément à l'invention de la première structure rigide équipée d'absorbeurs de chocs ;
- la figure 3, une vue en coupe horizontale, représente la structure rigide illustrée sur la figure 2 ;
- la figure 4, une vue en perspective, représente la structure rigide illustrée sur la figure 2 ;
- la figure 5, une vue en perspective, représente un exemple de réalisation conformément à l'invention de la seconde structure rigide équipée d'absorbeurs de chocs ;
- la figure 6, une vue de dessus, représente la structure rigide illustrée sur la figure 5 ;
- la figure 7, un diagramme fonctionnel, représente un exemple de procédé de détermination de la forme et de la constitution des absorbeurs de chocs ;
- la figure 8, une vue en coupe, représente un exemple de réalisation d'une liaison électrique élastique comprenant une pince élastique conductrice.

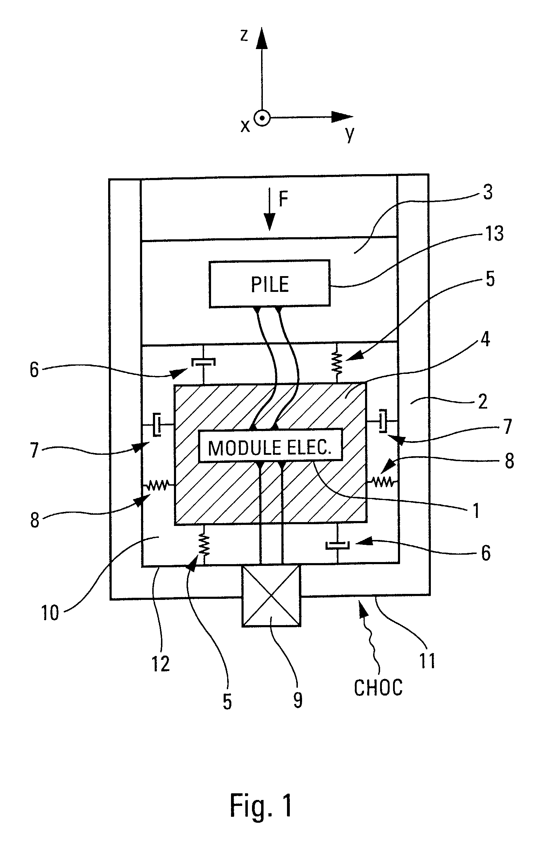

On se réfère maintenant à la figure 1 qui représente un exemple de réalisation de suspension d'un module électronique 1 conformément à l'invention. Cette suspension comprend une première structure rigide 2. Une seconde structure rigide 3 est destinée à être fixée à la première structure rigide 2. Lorsque ces deux structures sont fixées ensemble (position représentée sur la figure), elles forment une structure mécanique rigide, l'intérieur de cette structure mécanique formant une cavité 10. La structure mécanique rigide 2, 3 est destinée à recevoir un choc d'impact. Ce choc d'impact est transmis de l'extérieur 11 de la structure mécanique rigide à l'intérieur 12, c'est à dire à la surface de la cavité.

Le module électronique 1 est placé dans la cavité 10. Ce module peut être constitué par une ou plusieurs cartes électroniques par exemple. Les chocs d'impacts sont susceptibles d'endommager notamment les soudures des composants, les pistes des circuits imprimés, et les plots ou connexions de liaisons inter-cartes. Afin de protéger le module électronique 1 des chocs d'impacts transmis à la surface de la cavité, celui-ci est découplé mécaniquement de ladite surface.

Le découplage mécanique a pour but de réduire les niveaux et fréquences des chocs appliqués au module électronique. Il est réalisé au moyen :
- d'un enrobage rigide 4 du module électronique, et
- d'absorbeurs de chocs 5,6,7,8.

L'enrobage rigide 4 est indéformable et quasi incompressible. Avantageusement, il peut être constitué par une résine rigide, qui est facile et économique à réaliser. L'enrobage rigide 4 permet de ne pas générer de surtension ou de battement à l'intérieur du module électronique 1 lors des chocs d'impacts. En effet, les chocs d'impacts peuvent être vus comme une somme de chocs à différentes fréquences. Toute structure élastique peut engendrer des effets multiplicateurs sur les niveaux d'accélération rencontrés à certaines fréquences. La structure rigide 4 permet de ne pas amplifier ces chocs.

Un ou plusieurs absorbeurs de chocs 5, 6, 7, 8 sont destinés à être placés entre la surface 12 de la cavité et l'enrobage rigide 4. Ces absorbeurs de chocs ont un effet mécanique ressort 5, 8 et amortisseur 6, 7. Ils peuvent être avantageusement constitués par une matière élastique, telle qu'une résine élastique, qui combine ces deux effets. Ils permettent :
- de réduire les niveaux et fréquences des chocs appliqués au module électronique enrobé 1, 4,
- d'autoriser un débattement du module électronique enrobé 1, 4 dans la cavité 10.

Les absorbeurs de chocs 5, 6, 7, 8 sont précontraints lorsque la première 2 et la seconde 3 structure rigide sont fixées ensemble, par la cavité d'une part et l'enrobage rigide d'autre part. En d'autres termes, les absorbeurs de chocs 5, 6, 7, 8 sont destiné à être placés entre la surface 12 de la cavité et l'enrobage rigide 4 sans jeu. Ceci permet de les rendre actifs, en leur évitant de se mouvoir librement. A cet effet, les dimensions de la cavité et de l'enrobage rigide peuvent être déterminées de manière à appliquer cette force de précontrainte. Aucune structure mécanique intermédiaire n'est donc utilisée entre la surface 12 de la cavité et les absorbeurs de chocs 5, 6, 7, 8. Ainsi, on évite le risque d'amplification des chocs lié à l'ajout de pièces mécaniques intermédiaires.

On utilise dans la suite de la description un repère orthogonal direct (X,Y,Z). L'axe Z est l'axe vertical de ce repère, encore appelé composante axiale. Le plan horizontal (X,Y) correspond aux composantes transverses. Ce repère est illustré sur la figure 1.

Dans cet exemple, la structure mécanique 2, 3 est destinée à être embarquée dans une munition de pénétration. Le mouvement de cette munition se fait selon une direction principalement axiale. L'expérience montre cependant que lors pour des chocs d'impacts axiaux, les niveaux d'accélération susceptibles de détruire le module électronique sont présents selon les trois axes, c'est à dire aussi selon les composantes transverses. Par conséquent, les absorbeurs de chocs 5, 6, 7, 8 sont disposés de manière à amortir les chocs dans les toutes les directions. Bien entendu, pour d'autres applications, les absorbeurs de chocs peuvent être disposés pour n'amortir que les chocs selon une ou deux directions uniquement.

La seconde structure 3 rigide peut être fixée sur la première structure rigide 2 par un écrou (non représenté) par exemple. Cet écrou permet d'exercer une force F axiale, c'est à dire selon l'axe Z. Cet écrou exerce donc une force de précontrainte sur les absorbeurs de chocs 5, 6 à effet axial.

La cavité 10 peut avoir une forme de cylindre dont l'axe est orienté selon l'axe Z. L'enrobage 4 du module électronique peut aussi avoir une forme de cylindre. Le rayon de l'enrobage 4 est inférieur au rayon de la cavité 10. Lorsque le module électronique enrobé 1, 4 est dans la cavité 10, les axes de ces cylindres sont confondus. Les absorbeurs de chocs à effet transverse 7, 8 sont disposés entre les surfaces courbes de ces cylindres coaxiaux. La différence de rayons est telle que ces absorbeurs de chocs 7, 8 sont précontraints lorsque le module électronique enrobé 1, 4 est placé dans la cavité 10. Ainsi, les dimensions de la cavité et de l'enrobage rigide sont déterminées de manière à appliquer une force de précontrainte sur les absorbeurs de chocs 7, 8 à effet transverse. On note que cette force de précontrainte s'exerce même lorsque la seconde structure rigide n'est pas fixée sur la première structure rigide. Elle s'exerce donc à fortiori lorsque les deux structures rigides sont fixées ensemble.

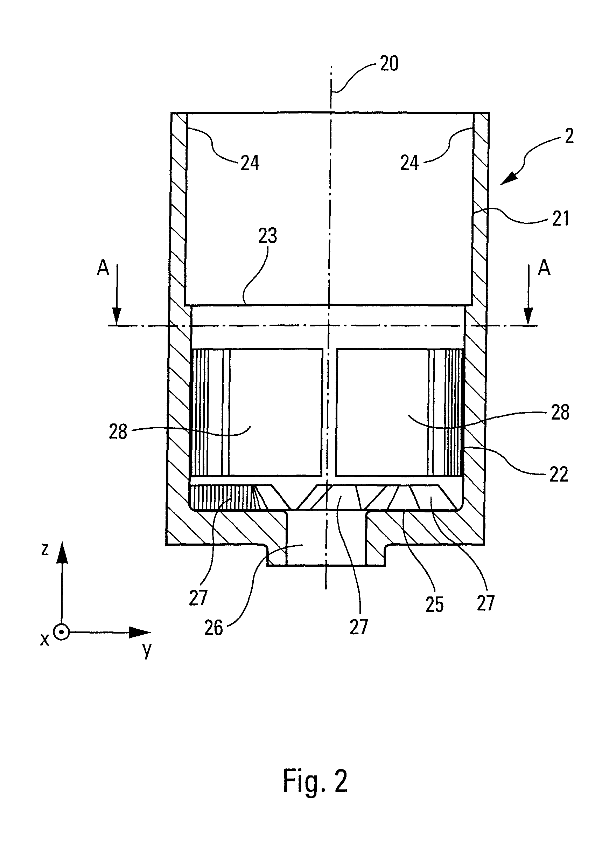

On se réfère maintenant aux figures 2 à 4 qui représentent un exemple de première structure rigide 2 équipés d'absorbeurs de chocs. Cette première structure rigide 2 peut être formée par une pièce globalement cylindrique en alliage d'aluminium par exemple. L'axe 20 de cette pièce est orienté selon l'axe Z. L'intérieur de cette pièce comprend un évidemment débouchant en haut de celle-ci. Cet évidemment est formé par deux cylindres 21, 22. Les axes des cylindres 21, 22 sont confondus avec l'axe 20. Le diamètre du cylindre 21 est supérieur au diamètre du cylindre 22. Le cylindre 21 est au-dessus du cylindre 22. Le bas 23 du cylindre 21 forme une butée pour la seconde structure rigide (non représentée). Cette butée est donc en haut du cylindre 22. Le bas 25 du cylindre 22 forme le fond de la cavité 10. La surface courbe du cylindre 22 forme la surface courbe de la cavité 10. La hauteur du cylindre 22 définit la hauteur de la cavité 10. Le diamètre du cylindre 22 définit le diamètre de la cavité 10.

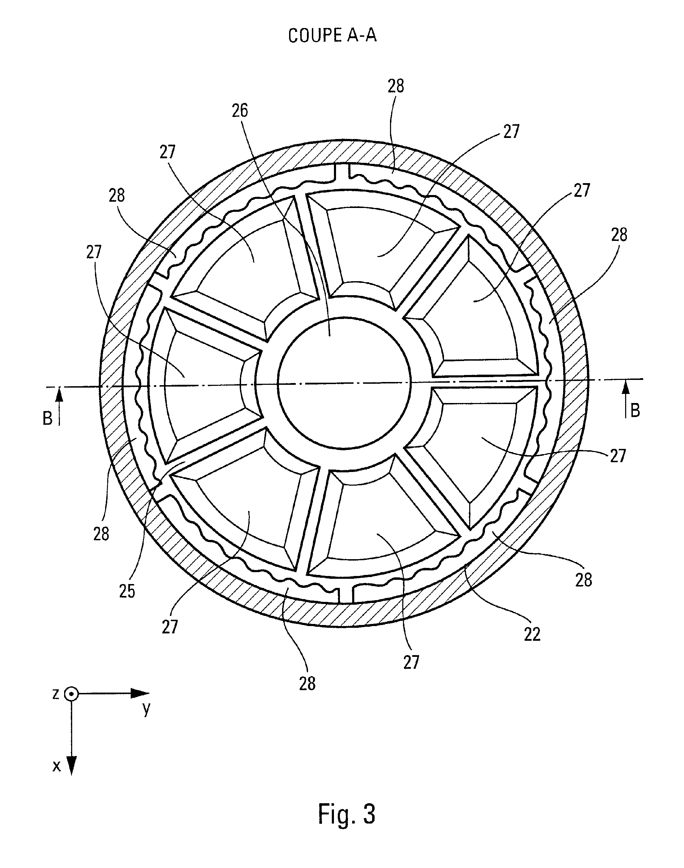

On se réfère à la figure 3 qui représente une coupe de la première structure rigide 2 dans le plan transverse (X,Y), le plan de coupe étant sous le cylindre 21. Des pièces 27 en résine élastique peuvent être moulées sur le bas 25 du cylindre 22, c'est à dire en bas de la cavité 10. Elles constituent une partie des absorbeurs de chocs à effet axial. Ces pièces élastiques 27 peuvent être au nombre de 7 par exemple.

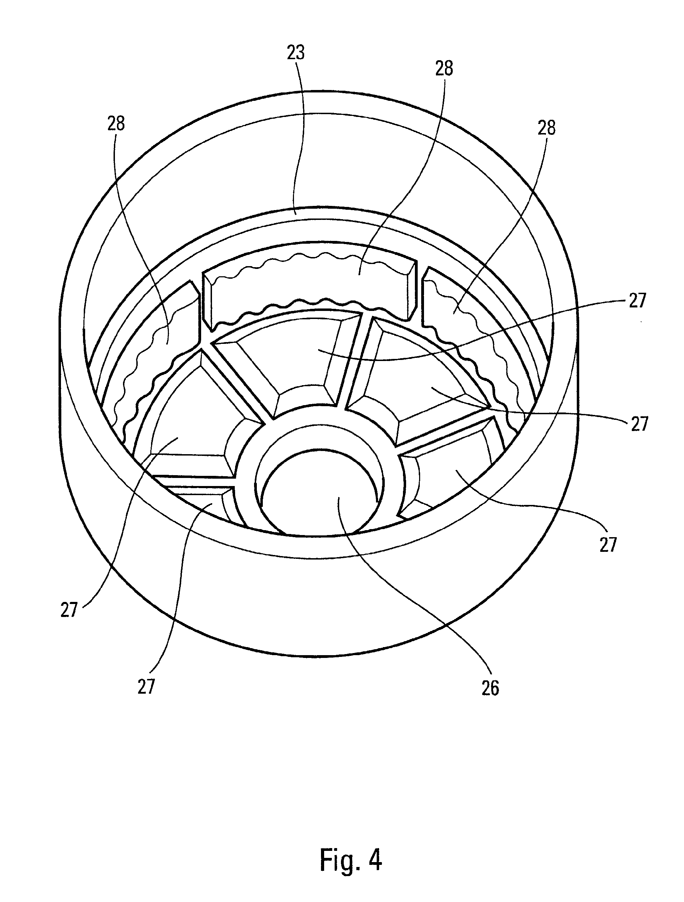

On se réfère à la figure 4 qui représente une vue en perspective de la première structure rigide 2. Des pièces 28 en résine élastique peuvent être moulées sur la surface courbe du cylindre 22. Elles constituent les absorbeurs de chocs à effet transverse. Ces pièces élastiques 28 peuvent être au nombre de 6 par exemple. La surface de ces pièces 28 peut être striée.

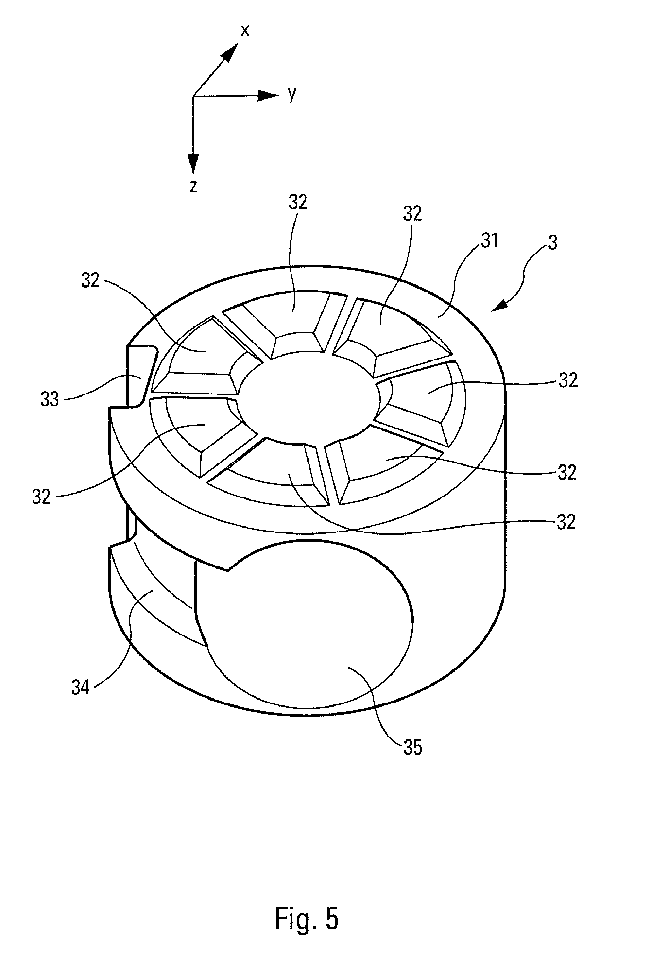

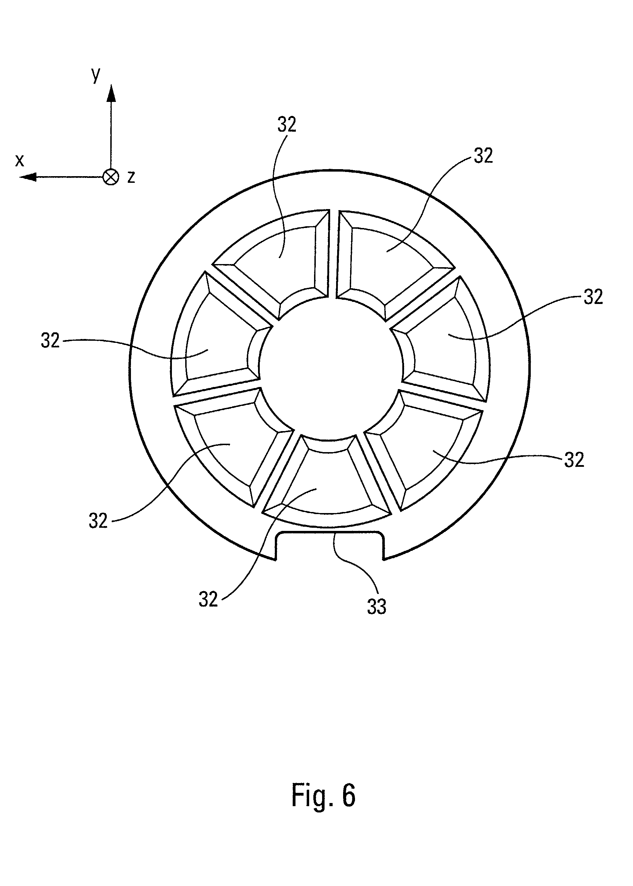

On se réfère maintenant aux figures 5 et 6 qui représentent un exemple de seconde structure rigide 3 équipés d'absorbeurs de chocs. Cette seconde structure rigide 3 peut être formée par une pièce globalement cylindrique en alliage d'aluminium par exemple. Le diamètre de cette pièce est inférieur à celui du cylindre 21 et supérieur à celui du cylindre 22. La seconde structure rigide est destinée à être insérée dans la partie supérieure de l'évidemment de la première structure rigide, c'est à dire dans le cylindre 21. La surface inférieure 31 de la seconde structure rigide 3 arrive en butée en haut du cylindre 22, c'est à dire en bas 23 du cylindre 21. La surface 31 forme le haut de la cavité 10.

Des pièces 32 en résine élastique peuvent être moulées sur la surface 31, c'est à dire en haut de la cavité 10. Elles constituent l'autre partie des absorbeurs de chocs à effet axial. Ces pièces élastiques 32 peuvent être au nombre de 7 par exemple.

On note que le montage de cette suspension est simple et rapide :
- on place le module électronique enrobé 1, 4 dans la première structure rigide équipée d'absorbeurs de chocs,
- on place la seconde structure rigide sur le module électronique enrobé,
- on visse l'écrou (non représenté) pour fixer la seconde structure rigide sur la première structure rigide.

Ainsi, l'invention permet d'assembler rapidement des suspensions pour module électronique. Ceci présente un avantage économique pour la production en série (de l'ordre de 10 000 exemplaires par exemple).

Les absorbeurs de chocs 27, 28, 32 étant moulés sur la surface de la cavité 10, ils adhèrent celle-ci. Cette adhérence permet d'éviter des effets mécaniques parasites. Il est possible, selon une variante, de mouler tout ou partie des absorbeurs de chocs sur l'enrobage rigide 4 plutôt que sur la surface de la cavité. Le montage reste le même.

Pour améliorer les performances, il est souhaitable de faire adhérer les absorbeurs de chocs à la fois à la cavité et à l'enrobage rigide 4. Ceci est possible en utilisant des techniques de moulage connues de l'homme du métier. Toutefois, l'assemblage en est rendu plus difficile. En outre, le désassemblage de la suspension risque de détruire les absorbeurs de chocs. Une autre solution consiste à faire adhérer les absorbeurs de chocs en les moulant d'un côté (soit sur la cavité, soit sur l'enrobage rigide) et en les collant de l'autre. L'assemblage en est facilité, et la colle peut alors être dissoute par exemple pour le désassemblage.

On note aussi que les absorbeurs de chocs occupent un volume réduit. Dans cet exemple, vu la géométrie de la cavité, on a réduit au maximum l'épaisseur des absorbeurs de chocs. Ces absorbeurs de chocs ont une faible épaisseur comparativement à leur surface.

La demanderesse a mis en évidence lors d'expérimentations pour les composants de type CMS (composants à montage de surface) une fragilité au niveau des jonctions fils/puce lors de l'application de chocs transverses à hautes fréquences. Avantageusement, la forme et la constitution des absorbeurs de chocs sont adaptées de manière à atténuer les accélérations (c'est à dire les chocs) transmises de la structure mécanique (première et seconde structure rigide) à l'enrobage rigide, cette atténuation étant suffisante pour protéger le module électronique contre des effets d'accélération (accélérations positives ou négatives) à des fréquences supérieures à 1kHz et de niveaux de G élevés.

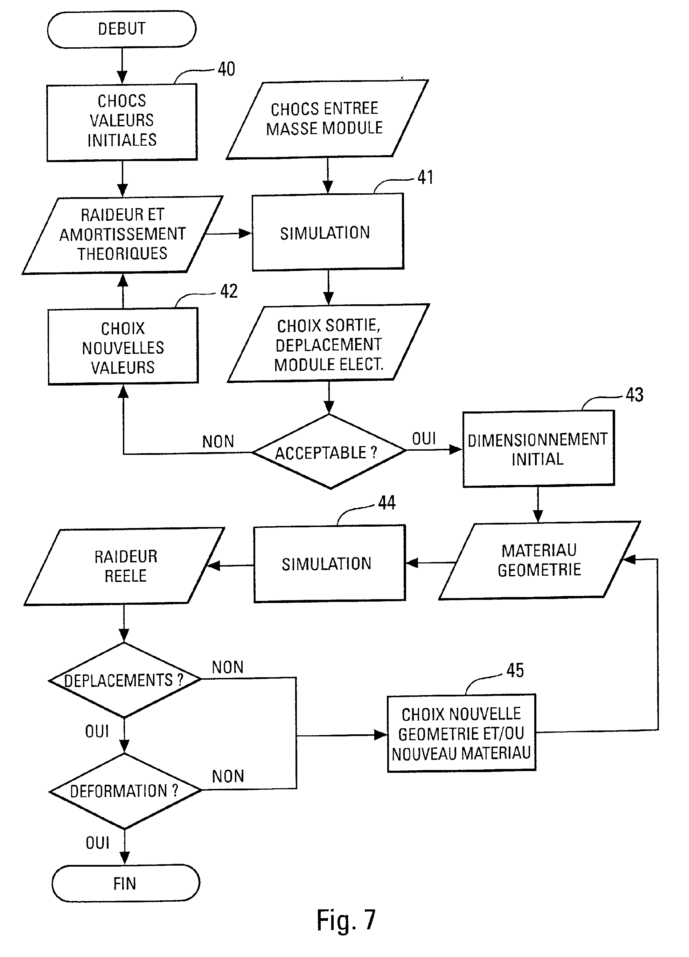

On se réfère maintenant à la figure 7 qui représente un exemple de procédé de détermination de la forme et de la constitution des absorbeurs de chocs. Ce procédé peut être utilisé pour déterminer la forme et la constitution d'absorbeurs de chocs occupant un volume réduit et atténuant suffisamment les accélérations à des fréquences supérieures à 1kHz.

Lors d'une première étape 40 choisit des valeurs initiales de raideur (effet ressort) et d'amortissement (effet amortisseur) des absorbeurs de chocs. Ce choix correspond à des valeurs théoriques, la forme et la constitution réelle des absorbeurs de chocs n'étant pas encore déterminée.

On réalise ensuite une simulation 41 pour déterminer le spectre des chocs transmis au module électronique. Elle permet de déterminer le spectre des chocs en sortie, c'est à dire transmis au module électronique. Pour réaliser cette simulation du spectre de choc transmis 41, on utilise notamment le spectre des chocs en entrée, c'est à dire le spectre des chocs appliqués à la structure mécanique. Le spectre des chocs en entrée peut être enregistré lors d'essais réels ou bien simulé. On utilise aussi les valeurs théoriques choisies à la première étape 40 ainsi que la masse du module enrobé. La masse du module enrobé peut être estimée.

A partir du spectre de chocs en sortie, on peut déterminer le déplacement du module électronique. Il suffit d'intégrer deux fois le spectre de chocs (intégrale double d'une accélération). Le déplacement maximum correspond à la distance séparant l'enrobage du module électronique de la cavité, cette distance étant diminuée de l'épaisseur minimale des absorbeurs de chocs.

Le déplacement du module électronique, déterminé à partir de la simulation 41, peut être trop important. Par ailleurs, le niveau des chocs en sortie (résultat de la simulation 41) peut être trop important pour le module électronique. Si tel est le cas (déplacement trop important ou niveau de chocs trop élevé), lors d'une étape 42, on choisit de nouvelles valeurs théoriques de raideur et d'amortissement. Ces nouvelles valeurs théoriques sont à nouveau testées lors de l'étape de simulation 41.

Si le niveau des chocs en sortie et le déplacement du module électronique sont acceptables, on réalise un dimensionnement initial 43 des absorbeurs de chocs. Lors de cette étape de dimensionnement 43, on choisit une géométrie et un matériau compatibles avec les valeurs de raideur et d'amortissement déterminées à l'étape 42. En d'autres termes, on choisit une forme et une constitution des absorbeurs de chocs.

On réalise ensuite une simulation 44. La simulation 44 peut être une simulation à éléments finis par exemple. Elle permet de déterminer la raideur réelle des absorbeurs de chocs dimensionnés à l'étape 43. On vérifie alors que cette raideur est compatible avec les déplacements maximums autorisés. On réalise au besoin une simulation 41.

Si les déplacements, correspondant à la raideur réelle, ne sont pas acceptables, on modifie 45 la géométrie des absorbeurs de chocs et/ou on choisit un nouveau matériau. On peut par exemple modifier le nombre de stries en surface des absorbeurs de chocs. En d'autres termes, on choisit lors d'une étape 45 une nouvelle géométrie (ou forme) d'absorbeurs de chocs. On retourne alors à l'étape de simulation 44.

Si les déplacements sont acceptables, il reste à vérifier que les déformations (en %) et les contraintes (en Pascal) sont acceptables par le matériau. Si la réponse est non, on peut modifier 45 la géométrie pour augmenter la surface de contact et/ou choisir un nouveau matériau acceptant des déformations plus grandes. On retourne alors à l'étape de simulation 44.

Si les déformations et les contraintes sont acceptables, on a fini la détermination de la forme et de la constitution des absorbeurs de chocs.

On se réfère à la figure 1. Le module électronique enrobé 1, 4 reçoit et envoie des ordres ou informations électriques à d'autres modules n'ayant pas besoin d'être protégés. C'est le cas notamment des modules ne devant pas fonctionner pendant ou après impact. C'est le cas aussi des modules résistant intrinsèquement aux chocs d'impact.

Ces autres modules peuvent être des modules électroniques ou des équipements. Ils ne sont pas protégés contre les niveaux de décélération et d'accélération. Cette protection serait inutile et pénaliserait le dimensionnement des absorbeurs de chocs. Il faudrait en effet pour protéger cette masse inutile, accroître le volume des absorbeurs de chocs pour atteindre une efficacité identique sans cette masse inutile.

Le module électronique enrobé 1, 4 est donc équipé d'une ou de plusieurs liaisons électriques vers ces autres modules. Ainsi, le dispositif selon l'invention comprend un premier module électronique 1, et une suspension 2, 3, 4, 5, 6, 7, 8, et un ou plusieurs seconds modules 13, 9. Ces seconds modules 13, 9 sont des modules électroniques ou des équipements. Ces seconds modules 13, 9 sont découplés mécaniquement du premier module électronique 1, mais relié électriquement à celui-ci.

Par exemple, le module 13 peut être une pile, telle qu'une pile thermique. Cette pile peut être fixée à la seconde structure rigide 3. La pile thermique fonctionne avant impact. Le module électronique 1 devant fonctionner une courte durée après l'impact, l'énergie stockée dans le circuit du premier module électronique 1 est suffisante. La pile thermique n'a plus besoin de fonctionner après l'impact.

Les liaisons avec la pile peuvent être détruites lors l'impact, c'est à dire lorsque la structure mécanique 2, 3 (première et seconde structures rigides) subissent des accélérations (positives ou négatives) violentes. Cette destruction ne perturbe pas le fonctionnement du premier module électronique 1. Avantageusement, ces liaisons peuvent être des liaisons électriques souples, telles que un ou plusieurs fils ou une nappe de fils.

On se réfère maintenant aux figures 5 et 6. La seconde structure rigide 3 comprend un logement 35 dans lequel peut être placée la pile. Des passages 33, 34 pour les fils d'alimentation peuvent être réalisés sur les côtés de la seconde structure rigide 3. Des nappes de fils peuvent être placées dans ces passages 33, 34 pour relier la pile et le module électronique 1.

Le logement 35 peut être par exemple une évidemment cylindrique d'axe horizontal situé dans la pièce constituant la seconde structure rigide 3. Le passage 33 peut être un évidemment pseudo parallélépipédiques vertical, débouchant de part et d'autre sur un côté de la pièce constituant la seconde structure rigide 3. Le passage 34 peut être un évidemment à section pseudo rectangulaire, sur un côté de la pièce, permettant de joindre le passage 33 et le logement 35.

D'autres modules (non représentés), tels que des circuits électroniques, peuvent être reliés au premier module électronique 1. Ces autres modules peuvent être placés sur la seconde structure rigide 3, c'est à dire à l'extérieur de la cavité 10. Le passage 33 peut être utilisé pour guider des fils ou des nappes de fils du premier module électronique 1 à ces autres modules.

Le module 9 peut être un détonateur par exemple. Ce module 9 résiste aux chocs d'impact sans nécessiter de protection particulière. C'est un composant mécanique rigide. Sa masse est relativement importante au regard du module électronique 1. Son intégration rigide sur le module électronique 1 pénaliserait le concepteur dans le dimensionnement des absorbeurs de chocs. Le détonateur 9 peut être découplé mécaniquement du module électronique 1, par exemple lié rigidement à la structure mécanique. Il peut être placé par exemple dans un logement de la première structure rigide 2 par exemple.

On se réfère maintenant aux figures 2 à 4. Le logement 26 dans lequel est placé le détonateur 9 peut être un évidemment cylindrique, d'axe confondu avec l'axe 20, et débouchant en bas de la première structure rigide 2 d'une part, et débouchant dans la cavité 10 d'autre part.

Le détonateur 9 peut être lié au module électronique 1 par une liaison électrique élastique. Cette liaison élastique permet d'accepter des mouvements relatifs entre le détonateur 9 et le module électronique 1 même lorsque la structure mécanique 2, 3 subit des accélérations (positives ou négatives) violentes. En d'autres termes, la liaison électrique entre le premier module 1 et l'un des seconds modules 9 peut être une liaison électrique élastique, cette liaison élastique permettant d'accepter les mouvements relatifs entre le premier 1 et le second 9 module, même lorsque la première 2 et la seconde 3 structures subissent des accélérations violentes.

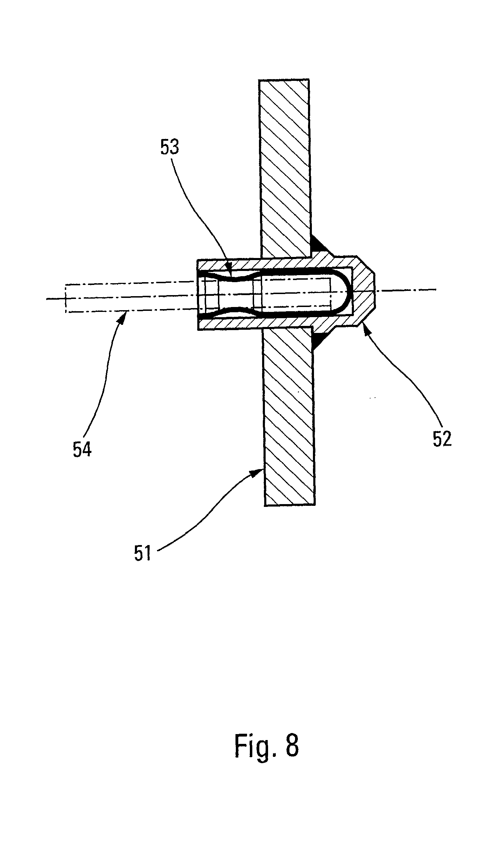

On se réfère maintenant à la figure 8. Des plots d'accueil élastiques peuvent être mis en place sur le module électronique 1. Ces plots 52, 53 sont soudés sur une carte 51 du module électronique 1. Chaque plot comprend une pince élastique conductrice 53 et une douille conductrice 52, la pince élastique 53 étant logée dans la douille 52. Des broches 54 du détonateur s'insèrent dans les plots, plus précisément dans les pinces élastiques 53.

Ainsi, la liaison électrique élastique entre le détonateur 9 et le module électronique 1 comprend une ou plusieurs pinces élastiques conductrices 53. Ces pinces 53 permettent ;
- d'établir un contact électrique entre le module électronique 1 et les broches du détonateur 9 lors de la mise à feu, la mise à feu intervenant après le choc d'impact ;
- d'accepter les mouvements relatifs du module électronique (mouvements axiaux et transverses) par rapport aux broches du détonateur 9 ;
- de faciliter le montage et le démontage du dispositif comprenant le détonateur, la suspension et le module électronique.

Les pinces élastiques 53 et les douilles 52 sont dimensionnés pour accepter les mouvements relatifs. On peut utiliser à cet effet les résultats des simulations effectuées pour dimensionner les absorbeurs de chocs (figure 7).

Avantageusement, des indexages peuvent être réalisés pour simplifier l'assemblage des autres modules avec le module électronique. Ces indexages permettent d'orienter entre les modules entre eux et/ou les modules avec les pièces. Par exemple, un indexage peut être placé sous la seconde structure rigide 3. Il peut être constitué par un ergot, moulé de la même manière que les absorbeurs de chocs. Lors du montage, cet indexage (non représenté) vient se loger dans un logement (non représenté) de l'enrobage 4 du module électronique. Cet indexage permet donc d'orienter en rotation la seconde structure rigide 3 par rapport au module électronique. Ainsi, des indexages peuvent être réalisés pour orienter entre eux le détonateur 9 ; le module électronique enrobé 1,4 ; et les structures rigides 2, 3.

L'invention bien sûr ne se limite pas à cet exemple de réalisation. La forme de la cavité peut être différente, parallélépipédique par exemple. L'enrobage du module électronique et les absorbeurs de chocs peuvent être réalisés avec d'autres matériaux que des résines. Ainsi le module électronique peut être surmoulé avec tout matériau de remplissage rigide et isolant. Les absorbeurs de chocs peuvent être collés ou moulés avec tout matériau de remplissage élastique.

## Revendications

1. Suspension pour module électronique (1) **caractérisée en ce qu'**elle comprend au moins ;
- une première structure rigide (2) ;
- une seconde structure rigide (3), destinée à être fixée à la première structure rigide, la première et la seconde structure formant une cavité (10) une fois fixées ensemble ;
- un ou plusieurs absorbeurs de chocs (5, 6, 7, 8), destinés à être en contact avec la surface de ladite cavité ;
- un enrobage rigide (4) du module électronique (1), destiné à être placé dans ladite cavité (10) en contact avec les absorbeurs de chocs (5, 6, 7, 8) et découplé mécaniquement de la cavité, les absorbeurs de chocs étant précontraints (F) lorsque la première et la seconde structure sont fixées ensemble, par la cavité d'une part et l'enrobage rigide d'autre part, chaque absorbeur de chocs adhérant à l'enrobage rigide ou à la cavité ou aux deux.

2. Suspension selon la revendication précédente, **caractérisée en ce que** les absorbeurs de chocs sont constitués par des dépôts de matière élastique (27, 28, 32).

3. Suspension selon l'une quelconque des revendications précédentes, **caractérisée en ce que** l'enrobage (4) est constitué par une résine rigide.

4. Suspension selon l'une quelconque des revendications précédentes, **caractérisée en ce que** la forme et la constitution des absorbeurs de chocs sont adaptées de manière à atténuer les accélérations transmises de la première et la seconde structure à l'enrobage rigide, et cette atténuation étant suffisante pour protéger le module électronique contre des effets d'accélération à des fréquences supérieures à 1kHz.

5. Dispositif comprenant un premier module électronique (1) et une suspension (2, 3, 4, 5, 6, 7, 8), selon l'une quelconque des revendications précédentes, pour ce premier module électronique, **caractérisé en ce qu'**il comprend un ou plusieurs seconds modules (13, 9), ces seconds modules étant des modules électroniques ou des équipements, ces seconds modules étant découplés mécaniquement du premier module électronique, mais relié électriquement à ce premier module.

6. Dispositif selon la revendication précédente, **caractérisé en ce que** l'un des seconds modules est fixé à la première ou à la seconde structure rigide.

7. Dispositif selon l'une quelconque des revendications 5 à 6, **caractérisé en ce que** la liaison électrique entre le premier module et au moins l'un des seconds modules est une liaison électrique souple, cette liaison électrique pouvant être détruite lorsque la première et la seconde structures subissent des accélérations violentes, cette destruction ne perturbant pas le fonctionnement du premier module électronique.

8. Dispositif selon la revendication précédente, **caractérisé en ce que** la liaison électrique souple est formée par un ou plusieurs fils ou une nappe de fils.

9. Dispositif selon l'une quelconque des revendications 5 à 8, **caractérisé en ce que** la liaison électrique entre le premier module et l'un des seconds modules est une liaison électrique élastique, cette liaison élastique permettant d'accepter les mouvements relatifs entre le premier et le second module, même lorsque la première et la seconde structures subissent des accélérations violentes.

10. Dispositif selon la revendication précédente, **caractérisé en ce que** la liaison électrique élastique est comprend une ou plusieurs pinces élastiques conductrices (53).
